# EUROPÄISCHE PATENTSCHRIFT

(11) **EP 4 098 088 B1**
(45) Veröffentlichungstag und Bekanntmachung des Hinweises auf die Patenterteilung: **13.05.2026**
(21) Anmeldenummer: 20820336.4
(22) Anmeldetag: 01.12.2020
(51) Int. Cl.: H05K 7/20

(54) **ANTRIEB, AUFWEISEND EINEN UMRICHTER**
DRIVING MECHANISM COMPRISING A RECTIFIER
MÉCANISME D'ENTRAÎNEMENT COMPRENANT UN REDRESSEUR

(30) Priorität: 27.01.2020 DE 102020000477
(43) Veröffentlichungstag der Anmeldung: 07.12.2022
(73) Patentinhaber: SEW-EURODRIVE GmbH & Co. KG, 76646 Bruchsal (DE)
(72) Erfinder: MAYER, Ralph, 76698 Ubstadt-Weiher (DE); DAMINGER, Franz, 67067 Ludwigshafen am Rhein (DE)
(86) Internationale Anmeldenummer: PCT/EP2020/025552
(87) Internationale Veröffentlichungsnummer: WO 2021/151454

(56) Entgegenhaltungen:
- EP-A1- 1 701 431
- EP-A2- 1 176 706
- DE-A1- 102005 037 488
- DE-B4- 102005 037 488

## Beschreibung

Die Erfindung betrifft einen Antrieb, aufweisend einen Umrichter.

Es ist allgemein bekannt, dass ein Antrieb einen von einem Umrichter gespeisten Elektromotor aufweist.

Aus der US 5 901 040 A ist eine Wärmesenke und Faraday'scher Käfig für ein Halbleitermodul bekannt.

Aus der US 5 508 908 A ist eine Motorsteuerung mit einer Kühlanordnung bekannt.

Aus der EP 2 270 961 A2 ist ein Elektromotor mit vorgeschaltetem Frequenzumrichter bekannt.

Aus der DE 10 2008 007 825 A1 ist ein Umrichtermotor bekannt.

Aus der DE 10 2007 014 713 B3 ist eine Kühlanordnung bekannt.

**Aus der** EP 1 701 431 A1 **ist ein Klemmenkasten für einen Elektromotor bekannt.**

**Aus der** EP 1 176 706 A2 **ist ein Frequenzumrichter mit einem aus Oberteil und Unterteil bestehenden Gehäuse bekannt.**

**Aus der** DE 10 2005 037 488 A1 **ist ein Gerät bekannt.**

Der Erfindung liegt die Aufgabe zugrunde, einen Antrieb möglichst kompakt und mit hoher Standzeit weiterzubilden.

Erfindungsgemäß wird die Aufgabe bei der nach den in Anspruch 1 angegebenen Merkmalen gelöst.

Von Vorteil ist dabei, dass eine effiziente Entwärmung erreichbar ist. Denn die Leistungselektronik des Umrichters ist über den Kühlkörper entwärmbar und die Signalelektronik über das Deckelteil. Dabei sind das Deckelteil und der Kühlkörper aus Metall ausgeführt, vorzugsweise beide aus Aluminium. Da jedoch der von der Signalelektronik erzeugte Wärmestrom kleiner ist als der von der Leistungselektronik, ist das Deckelteil alternativ auch aus Stahlguss ausführbar.

Infolge der großen Ausdehnung des Kühlkörpers, welcher sich über dem Deckelteil über mehrere Seiten erstreckt, ist eine leistungsfähige Entwärmung ermöglicht und somit eine kompakte Ausführung des Umrichters. Außerdem ist durch die Entwärmung der Signalelektronik durch das Deckelteil zur Umgebung hin und die davon separate Entwärmung des Leistungsmoduls, mittels des Kühlkörpers zur Umgebung hin eine hohe Standzeit erreichbar. Denn die Wärmebelastung der Bauelemente der Signalelektronik ist reduzierbar und somit deren Standzeit erhöht.

Bei einer vorteilhaften Ausgestaltung ist der Jochbereich im Wesentlichen eben ausgeführt und das Deckelteil an seiner vom Elektromotor abgewandten Seite zumindest teilweise abdeckt. Von Vorteil ist dabei, dass der Kühlkörper mit seinem Jochbereich zumindest teilweise eben am Deckelteil anliegt. Somit ist eine Entwärmung kompakt erreichbar.

Bei einer vorteilhaften Ausgestaltung sind die insbesondere drei Schenkelbereiche am Jochbereich abgewinkelt, insbesondere senkrecht abgewinkelt, angeordnet. Von Vorteil ist dabei, dass die Schenkelbereiche seitlich das Deckelteil zumindest teilweise abdecken. Auf diese Weise ist in verschiedenen Montagerichtungen eine effiziente Entwärmung der Leistungselektronik ermöglicht.

Bei einer vorteilhaften Ausgestaltung erstreckt sich jeder der Schenkelbereiche jeweils parallel zur Normalenrichtung des ebenen Jochbereichs, insbesondere weg vom Elektromotor. Von Vorteil ist dabei, dass das Deckelteil seitlich an drei Seiten umfassbar ist. Somit ist eine effiziente Entwärmung ermöglicht. Dadurch, dass nämlich eine Wärmesperre zwischen dem Deckelteil und dem Kühlkörper angeordnet ist, ist eine Entwärmung des Kühlkörpers zur Umgebung hin ermöglicht, wobei die äußere Oberfläche des Kühlkörpers an mehreren verschieden ausgerichteten Seiten zur Umgebung hin zugänglich ist und das Deckelteil trotzdem auch zur Umgebung hin offene Oberflächenbereiche aufweist. Dabei genügt auch eine kleinere freie Oberfläche des Deckelteils, da die Signalelektronik weniger Wärmeleistung erzeugt als die Leistungselektronik. Das Deckelteil muss keine Kühlrippen aufweisen, der Kühlkörper jedoch ist bevorzugt mit Kühlrippen ausgeführt.

**Erfindungsgemäß** deckt jeder der Schenkelbereiche eine zur ersten Seite und zu den von den anderen Schenkelbereichen abgedeckten Seiten unterschiedliche Seite des Deckelteils zumindest teilweise ab. Von Vorteil ist dabei, dass die Schenkelbereiche nicht übereinander gestapelt anordenbar sind, sondern zwischen jeweils zwei Schenkelbereichen stets das Deckelteil angeordnet ist. Somit umgreift der Kühlkörper das Deckelteil. Der Kühlkörper ist also nur in einer einzigen Richtung vom Deckelteil abziehbar, die senkrecht zur Normalenrichtung des Jochbereichs ausgerichtet ist, und entgegen der Aufsteckrichtung, also parallel zur Normalenrichtung des Jochbereichs.

Bei einer vorteilhaften Ausgestaltung ist die B-seitige Seite des Deckelteils, also diejenige Seite des Deckelteils, welche vom aus dem Statorgehäuse des Elektromotors herausstehenden, die Last antreibenden Ende der Rotorwelle am weitesten entfernt, vom Kühlkörper nicht abgedeckt ist. Von Vorteil ist dabei, dass eine Seite des Deckelteils noch frei ist und somit eine Entwärmung einfach ausführbar ist.

**Erfindungsgemäß** umgeben das Unterteil und das mit dem Unterteil verbundene Deckelteil einen Raumbereich, in welchem eine Leiterplattenanordnung angeordnet ist, welche mit zumindest einem Wärme erzeugenden Bauelement, einer Signalelektronik des Umrichters, und mit einem Leistungsmodul des Umrichters bestückt ist,
wobei das Leistungsmodul mit dem Kühlkörper wärmeleitend verbunden ist und das Bauelement mit dem Deckelteil wärmeleitend verbunden ist. Von Vorteil ist dabei, dass die Signalelektronik separat von der Leistungselektronik entwärmt wird. Somit sind verschieden hohe Temperaturniveaus realisierbar, wobei die Signalelektronik auf einem ersten Temperaturniveau und das Leistungsmodul auf einem zweiten Temperaturniveau arbeitet.

**Erfindungsgemäß** umfasst die Wärmesperre ein Isoliermittel, welches an einem dem Deckelteil zugewandten Oberflächenbereich des Kühlkörpers angeordnet ist. Von Vorteil ist dabei, dass das Isoliermittel elektrisch und thermisch isolierend wirkt. Somit ist das Leistungsmodul elektrisch derart mit dem Kühlkörper verbindbar, dass dieser auf einem am Leistungsmodul vorhandenen elektrischen Potential insbesondere des Leistungsmoduls liegt, und die Signalelektronik mit dem Deckelteil ebenfalls ein gemeinsames Potential aufweist. Zwischen der Signalelektronik und dem Leistungsmodul ist eine galvanische Trennung auf der Leiterplatte realisiert. Somit sind also auch das Deckelteil und der Kühlkörper potentialgetrennt.

Bei einer vorteilhaften Ausgestaltung umfasst die Wärmesperre thermisch und elektrisch isolierende Schichten oder Materialien, die zur Isolierung von Befestigungsmitteln vorgesehen sind, wobei die Befestigungsmittel den Kühlkörper mit dem Deckelteil verbinden, insbesondere wobei die Befestigungsmittel Schrauben sind. Von Vorteil ist dabei, dass zwar eine mechanische Befestigung durch die Befestigungsmittel bewirkt ist aber keine elektrische oder thermische Verbindung.

**Erfindungsgemäß** ist zwischen dem Bauelement und dem Deckelteil Füllmaterial angeordnet, das sowohl mit dem Bauelement als auch mit dem Deckelteil stoffschlüssig verbunden ist,
wobei das Füllmaterial Keramikpartikel aufweist und wärmeleitend ist, insbesondere
wobei die Wärmeleitfähigkeit des Füllmaterials sich von der Wärmeleitfähigkeit von Wärmeleitpaste eine um weniger als einen Faktor 2 unterscheidet. Von Vorteil ist dabei, dass der Wärmeübergangswiderstand vom Bauelement zum Deckelteil äußerst gering ist und somit eine effiziente Wärmeleitung durch das Füllmaterial ausführbar ist. Auf diese Weise ist eine Entwärmung des Bauelements über das Deckelteil ermöglicht, obwohl zwischen Bauelement und Deckelteil eine Beabstandung realisiert ist. Im Gegensatz zur Verwendung von Wärmeleitpaste wird das Bauelement nicht direkt an das Deckelteil angedrückt, sondern weist einen Abstand auf, der durch das Füllmaterial überbrückbar ist. Beim Befestigen der Leiterplatte, auf welcher das Bauelement bestückt ist, am Deckelteil, wird das Füllmaterial elastisch verformt.

Bei einer vorteilhaften Ausgestaltung ist das Füllmaterial mehrstückig ausgeführt,
wobei einem jeweiligen, insbesondere Wärmeerzeugenden, auf der Leiterplattenanordnung, insbesondere auf einer Leiterplatte der Leiterplattenanordnung, bestückten Bauelement ein jeweiliges Füllmaterialstück zugeordnet ist, insbesondere eineindeutig zugeordnet ist, insbesondere wobei die Fläche der senkrechten Projektion des Füllmaterialstücks in die Leiterplattenebene die Fläche der senkrechten Projektion des Bauelements in die Leiterplattenebene nur um weniger als 50% übertrifft. Von Vorteil ist dabei, dass bei der Herstellung jedem Bauelement mittels einer Dispersionsvorrichtung Füllmaterial zuordenbar ist. Daher ist das Füllmaterial in materialsparender Weise einsetzbar und trotzdem jeder Wärme erzeugende, auf der Leiterplatte bestückte Bauelement der Signalelektronik effizient über das Deckelteil entwärmbar.

Bei einer vorteilhaften Ausgestaltung ist das Füllmaterial derart elastisch ausgeführt, dass diejenigen Änderungen des Abstands zwischen Deckelteil und Bauelement, welche beim Betrieb des Umrichters thermisch bedingt sind, im elastischen Bereich der Verformung des Füllmaterials kompensierbar sind. Von Vorteil ist dabei, dass der im Betrieb auftretende Temperaturhub die durch das Füllmaterialbereitgestellte wärmeleitende Verbindung nicht verschlechtert.

Bei einer vorteilhaften Ausgestaltung ist zwischen dem Kühlkörper und dem Leistungsmodul Wärmeleitpaste angeordnet. Von Vorteil ist dabei, dass das Leistungsmodul an den Kühlkörper angedrückt wird und durch die Wärmeleitpaste der Wärmeübergangswiderstand verringert wird, dass dieses auch in sehr kleine Vertiefungen der Kontaktfläche zwischen Füllmaterial und Deckelteil oder Bauelement eindringt.

Erfindungsgemäß weist das Deckelteil eine Ausnehmung auf, durch welche das Leistungsmodul und der Kühlkörper hindurchragt.

Von Vorteil ist dabei, dass das Leistungsmodul auf der Leiterplatte bestückt ist und die Leiterplatte vom Deckelteil umgeben ist und trotzdem die Wärme separat an einen Kühlkörper ableitbar ist, welcher außerhalb des Deckelteils angeordnet ist. Insbesondere ist das Deckelteil zwischen Kühlkörper und Leiterplatte angeordnet.

**Erfindungsgemäß** ist das Isoliermittel zwischen dem Kühlkörper und dem Deckelteil angeordnet,
wobei das Isoliermittel sowohl dicht verbunden ist mit dem Kühlkörper als auch mit dem Deckelteil,
wobei das Isoliermittel aus einem Kunststoff gefertigt ist und als Wärmesperre fungiert und/oder aus einem elektrisch isolationsfesten Material gefertigt ist. Von Vorteil ist dabei, dass mittels des Isoliermittels der Raumbereich, in welchem das Leistungsmodul angeordnet ist, abgedichtet ist gegen die Umgebung. Denn der Kühlkörper ist zwar vom Deckelteil beabstandet, aber das Isoliermittel füllt - umlaufend um die Ausnehmung des Deckelteils, durch welche das Leistungsmodul hindurchragt, - den Beabstandungsbereich auf, der zwischen dem Kühlkörper und dem Deckelteil gebildet ist.

**Erfindungsgemäß** weist das Isoliermittel einen um das Leistungsmodul umlaufenden Kragenbereich auf, der an die Leiterplatte angrenzt. Von Vorteil ist dabei, dass das Leistungsmodul von den auf der Leiterplatte bestückten Bauelementen der Signalelektronik verbessert, thermisch und elektrisch isoliert anordenbar ist.

Bei einer vorteilhaften Ausgestaltung weist der Antrieb einen Elektromotor auf, auf dem der Umrichter angeordnet ist. Von Vorteil ist dabei, dass der Umrichter, umfassend das Leistungsmodul, vorzugsweise auf der vom Elektromotor abgewandten Seite des Umrichters entwärmbar ist.

Bei einer vorteilhaften Ausgestaltung weist der Kühlkörper an seiner Außenseite Kühlrippen auf,
welche auf der vom Elektromotor abgewandten Seite des Kühlkörpers derart gebogen ausgebildet sind, dass sie sich von einer jeweiligen Seitenfläche zu mindestens zwei anderen Seitenflächen, insbesondere zu drei Seitenflächen, erstrecken. Von Vorteil ist dabei, dass bei unterschiedlichen Montagerichtungen einerseits ein Kühlluftstrom entlang der Kühlrippen ausbildbar ist und andererseits das Abfließen von Wasser ermöglicht ist, also sich nicht zwischen den Kühlrippen ansammelt.

Bei einer vorteilhaften Ausgestaltung ist ein zusätzlicher Lüfter am Kühlkörper angeordnet, insbesondere wobei der vom Lüfter geförderte Luftstrom zumindest teilweise entlang der Oberfläche des Kühlkörpers strömt. Von Vorteil ist dabei, dass eine effizientere Kühlung ausbildbar ist. Dabei ist der Lüfter mit einer Lüfterhaube ausbildbar, welche mit dem Kühlkörper derart verbindbar ist, dass der geförderte Kühlluftstrom ohne wesentliche Verluste entlang der Kühlrippen strömt.

Die Erfindung wird nun anhand von schematischen Abbildungen näher erläutert:

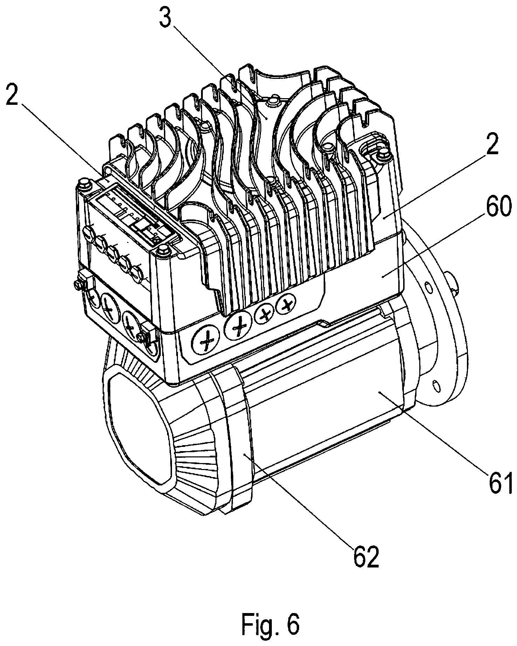

In der Figur 6 ist ein erfindungsgemäßer Antrieb, aufweisend einen Elektromotor 61 mit Umrichter, der ein Unterteil 60 und ein darauf aufgesetztes Deckelteil 2 mit darüber gestülptem Kühlkörper 3 aufweist, gezeigt.

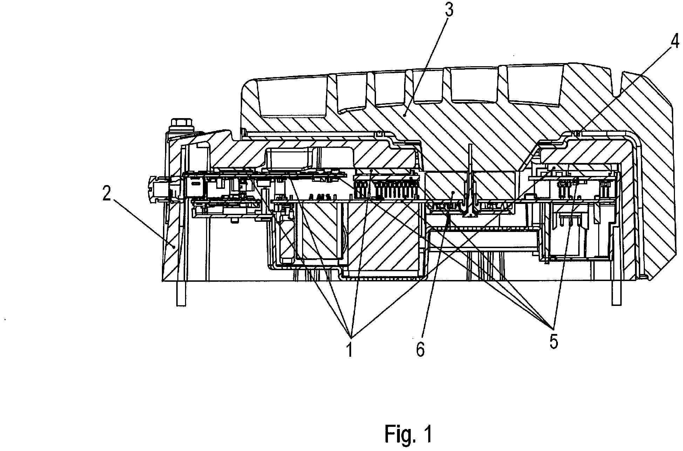

In der Figur 1 ist ein Querschnitt durch den Umrichter schematisch skizziert.

In der Figur 2 ist der Umrichter explodiert in Schrägansicht dargestellt.

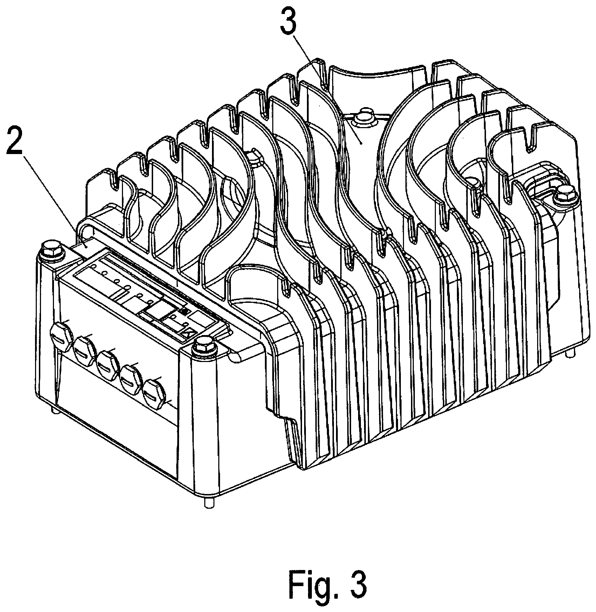

In der Figur 3 ist das Deckelteil 2 mit aufgesetztem Kühlkörper 3 in Schrägansicht dargestellt.

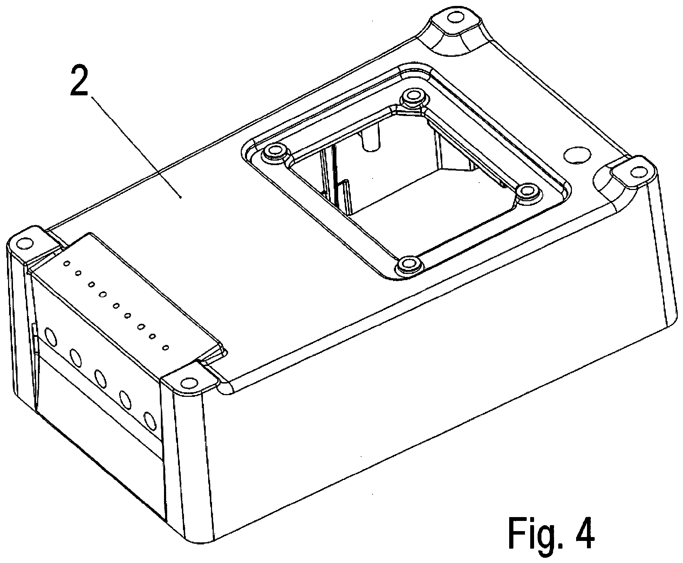

In der Figur 4 ist das Deckelteil 2 in Schrägansicht dargestellt.

In der Figur 5 ist ein Kühlkörper 3 für sich allein in Schrägansicht mit Blickrichtung vom Elektromotor 61 her dargestellt.

In der Figur 7 ist ein optional verwendbares, zwischen Deckelteil 2 und Kühlkörper 3 zwischengeordnete Isoliermittel 4 in Schrägansicht dargestellt.

Wie in den Figuren dargestellt, weist der Antrieb einen Elektromotor 61 auf, dessen Rotorwelle mit einem Lüfter drehfest verbunden ist, welcher von einer Lüfterhaube 62 abgedeckt ist.

Am Elektromotor 61 ist ein Umrichter angeordnet, der ein Unterteil 60 aufweist und ein Deckelteil 2, das auf das Unterteil 60 aufgesetzt und dicht verbunden ist mit dem Unterteil 60. Auf das Deckelteil 2 ist ein Kühlkörper 3 aufgesteckt.

Das Unterteil 60 ist mit dem Statorgehäuse des Elektromotors 61 verbunden, wobei das Unterteil 60 und das Statorgehäuse jeweils eine Ausnehmung aufweisen, durch welche der Wicklungsdraht der Statorwicklung von der Statorwicklung in denjenigen Innenraumbereich geführt ist, welcher vom Unterteil 60 und Deckelteil 2 umgeben ist.

In diesem Innenraumbereich ist ein Steckverbinderteil, das auf einer am Unterteil 60 oder am Deckelteil 2 befestigten ersten Leiterplatte einer Leiterplattenanordnung bestückt ist, mit einem dazu korrespondierenden Gegensteckverbinderteil steckverbunden, das auf einer zweiten Leiterplatte der Leiterplattenanordnung bestückt ist, wobei die zweite Leiterplatte am Deckelteil 2 befestigt ist. Die Statorwicklung ist vorzugsweisen mit Kontakten des ersten Steckverbinderteils elektrisch verbunden.

Die erste und/oder zweite Leiterplatte ist mit der Signalelektronik des Umrichters bestückt, welche geeignet ist, pulsweitenmodulierte Ansteuersignale für die Halbleiterschalter der Leistungselektronik des Umrichters zu erzeugen. Dabei sind die Halbleiterschalter in einem Leistungsmodul 6 integriert angeordnet, dessen Anschlüsse elektrisch verbunden sind mit Leiterbahnen der ersten Leiterplatte. Auf der von seinen Anschlüssen abgewandten Seite des Leistungsmoduls 6 ist das Leistungsmodul 6 auf eine vorzugsweise fein bearbeitete Kontaktfläche des Kühlkörpers 3 gedrückt, so dass das Leistungsmodul 6 den Kühlkörper 3 an dieser Kontaktfläche berührt. Vorzugsweise ist dieses Andrücken durch eine durch das Leistungsmodul durchgehende Schraube bewirkt, deren Schraubenkopf das Leistungsmodul 6 zum Kühlkörper hin andrückt, weil der Gewindebereich der Schraube in eine in den Kühlkörper eingebrachte Gewindebohrung zumindest teilweise eingeschraubt ist.

Im Bereich der Kontaktfläche ist vorzugsweise Wärmeleitpaste vorgesehen, so dass der Wärmeübergangswiderstand zwischen Leistungsmodul 6 und Kühlkörper 3 verringert ist.

Die Halbleiterschalter des Leistungsmoduls 6 sind in zueinander parallel geschalteten Halbbrücken angeordnet, wobei diese Parallelschaltung aus einer Gleichspannung versorgt ist. Somit bilden die vorzugswiese drei Halbbrücken einen Wechselrichter, welcher dem Elektromotor 61 eine vorzugsweise dreiphasige Wechselspannung zur Verfügung stellt.

Das Unterteil 60 ist mit dem Statorgehäuse dicht verbunden. Außerdem ist auch das Deckelteil 2 mit dem Unterteil 60 dicht verbunden.

Das Deckelteil 2 weist an seiner vom Elektromotor, insbesondere Statorgehäuse, abgewandten Seite eine Ausnehmung auf, durch welche ein Bereich des Kühlkörpers 3 hindurchragt in den Innenraumbereich bis zum Leistungsmodul 6. Das Leistungsmodul 6 ist vorzugsweise innerhalb des Innenraumbereichs angeordnet.

Das Deckelteil 2 ist vorzugsweise aus Metall, insbesondere Aluminium-Druckguss, ausgeführt.

Der Kühlkörper 3 ist vorzugsweise aus Metall, insbesondere Aluminium-Druckguss, ausgeführt.

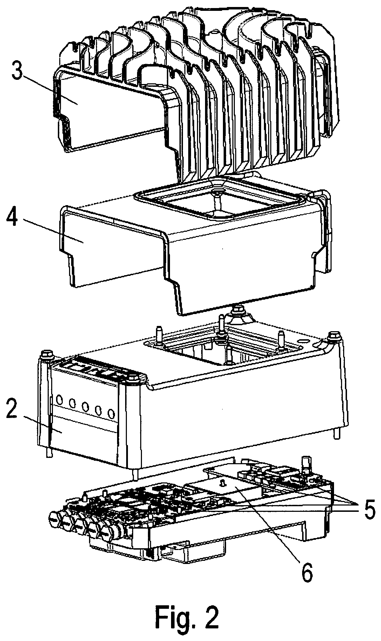

Zwar ist der Kühlkörper 3 mit dem Leistungsmodul 6 wärmeleitend verbunden, jedoch ist zwischen dem Kühlkörper 3 und dem Deckelteil 2 eine elektrische und thermische Isolierung angeordnet. Dabei sind metallische Verbindungsmittel, welche den Kühlkörper 3 mit dem Deckelteil 2 verbinden, mit einem oder mehreren, zwischen Deckelteil 2 und Kühlkörper 3 zwischengeordnetem Kunststoffteilen verbunden. Die Isolierung umfasst aber nicht nur die genannten Verbindungsmittel, sondern auch ein Isolationsmittel 4, das in Figur 2 näher dargestellt ist und die dem Deckelteil 2 zugewandte Innenseite des Kühlkörpers 3 bedeckt. Das Isolationsmittel 4 ist aus einem elektrisch und thermisch isolierendem Material, wie Kunststoff oder dergleichen gefertigt. Es muss nicht als separates Teil ausgeführt sein, sondern darf auch als Verbundteil mit dem Kühlkörper 3 ausgebildet sein, insbesondere beispielsweise auch als Kunststoffbeschichtung oder andere stoffschlüssig mit dem Kühlkörper 3 verbundene Schicht.

Auf der Leiterplattenanordnung 5, insbesondere zweiten Leiterplatte, sind Wärme erzeugende Bauelemente bestückt, die mittels Füllmaterial 1 wärmeleitend mit dem Deckelteil 2 verbunden sind.

Somit ist die Signalelektronik des Umrichters über das Deckelteil 2 entwärmt und die Leistungselektronik des Umrichters über den Kühlkörper 3.

Das zwischen der jeweiligen Wärme erzeugenden, auf der zweiten Leiterplatte bestückten Bauelement und dem Deckelteil 2 angeordneten jeweiligen Füllmaterial 1 ist stoffschlüssig verbunden sowohl mit dem Deckelteil 2 als auch mit dem jeweiligen Bauelement. Außerdem ist das Füllmaterial 1 derart elastisch, dass die durch die bei Betrieb des Antriebs auftretenden thermischen Hübe bewirkten Längenveränderungen zwischen Deckelteil 2 und zweiter Leiterplatte im elastischen Bereich des Füllmaterials 1 liegen, also aufnehmbar sind vom Füllmaterial 1, insbesondere durch elastische Auslenkung des Füllmaterials 1.

Die Wärmeleitfähigkeit des Füllmaterials 1 unterscheidet sich von der Wärmeleitfähigkeit von Wärmeleitpaste um weniger als den Faktor 2.

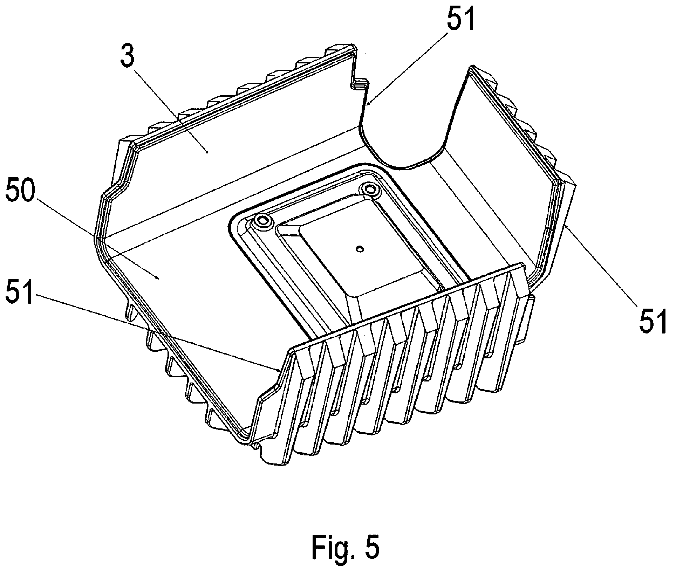

Wie in Figur 5 gezeigt, weist der Kühlkörper 3 Schenkelbereiche 51 auf, die zwar voneinander beabstandet sind aber alle mit einem Jochbereich 50 verbunden sind. Der Jochbereich 50 ist vorzugsweise eben ausgeführt und deckt das Deckelteil 2 an seiner vom Elektromotor 61 abgewandten Seite ab.

Die drei Schenkelbereiche 51 sind am Jochbereich 50 abgewinkelt angeordnet und erstrecken sich jeweils parallel zur Normalenrichtung des ebenen Jochbereichs 50, insbesondere weg vom Elektromotor 61.

Jeder der Schenkelbereiche 51 deckt ebenfalls eine Seite des Deckelteils 2 zumindest teilweise ab.

Somit ist nur die B-seitige Seite, also diejenige Seite des Deckelteils 2, welche auf der dem aus dem Statorgehäuse des Elektromotors 61 herausstehenden, die Last antreibenden Ende der Rotorwelle am weitesten entfernt ist, vom Kühlkörper 3 nicht abgedeckt.

Das Deckelteil 2 bildet zusammen mit dem Unterteil 60 ein im Wesentlichen quaderförmiges Gehäuse.

Durch die gegenseitige Beabstandung der Schenkelbereiche 51 voneinander sind die Eckbereiche des Deckelteils 2 nicht vom Kühlkörper 3 abgedeckt und somit können Schrauben betätigt werden, welche im jeweiligen Eckbereich angeordnet und durch das Deckelteil 2 hindurchgehen und mit ihrem Gewindebereich in Gewindebohrungen des Unterteils 60 eingeschraubt sind, so dass die Schraubenköpfe dieser Schrauben das Deckelteil 2 an das Unterteil 60 andrücken.

Wie in Figur 2 gezeigt, deckt das Isoliermittel 4 die Innenseite des Kühlkörpers 3 ab. Somit ist der Kühlkörper 3 vom Deckelteil 2 elektrisch und thermisch isoliert.

Das Isoliermittel 4 weist ebenso wie das Deckelteil eine Ausnehmung auf, durch welche das Leistungsmodul 6 hindurchragt und auf der Kontaktfläche des Kühlkörpers 3 aufliegt, wobei Wärmeleitpaste zwischengeordnet ist.

Der Kühlkörper 3 weist an seiner Außenseite Kühlrippen auf. Diese sind auf der vom Elektromotor 61 abgewandten Seite des Kühlkörpers 3 derart gebogen ausgebildet, dass sie sich von einer jeweiligen Seitenfläche zu mindestens zwei anderen Seitenflächen, insbesondere zu drei Seitenflächen, erstrecken.

Das Füllmaterial 1 ist vorzugsweise mehrstückig ausgeführt. Hierbei ist jedem auf der Leiterplatte bestückten Bauelement ein Füllmaterialstück zugeordnet. Bei der Herstellung des Antriebs wird flüssiges, Pasten artiges Material mit einer Dispersionsvorrichtung stückweise auf das Bauelement oder alternativ auf die Innenseite des Deckelteils 2 aufgebracht. Beim Zusammenfügen der Leiterplatte und dem Deckelteil 2 wird das Material härter und bildet somit das jeweilige Füllmaterialstück. Dieses jeweilige Füllmaterialstück ist jedoch immer noch elastisch verformbar und ist stoffschlüssig verbunden mit dem jeweiligen Bauelement und dem Deckelteil 2. Das Füllmaterialstück überdeckt das jeweilige Bauelement nur etwas. Insbesondere übertrifft die Fläche der senkrechten Projektion des Füllmaterialstücks in die Leiterplattenebene die Fläche der senkrechten Projektion des Bauelements in die Leiterplattenebene nur um weniger als 50%. Somit ist dem jeweiligen Wärmeerzeugenden auf der Leiterplatte bestückten Bauelement ein jeweiliges Füllmaterialstück insbesondere eineindeutig zugeordnet.

Erfindungsgemäß ist also der Antrieb als Umrichtermotor insbesondere derart ausgeführt, dass der Umrichter einen Kühlkörper 3 aufweist, der ein Deckelteil 2 des Umrichters umgreift. Außerdem sind Füllmaterialstücke zwischen Bauelementen der Signalelektronik und dem Deckelteil vorhanden. Das Leistungsmodul 6 ragt durch eine Ausnehmung des Deckelteils 2 und ist thermisch verbunden mit dem Kühlkörper 3. Zwischen Kühlkörper 3 und Deckelteil 2 ist ein elektrisch und thermisch wirkendes Isolationsmittel.

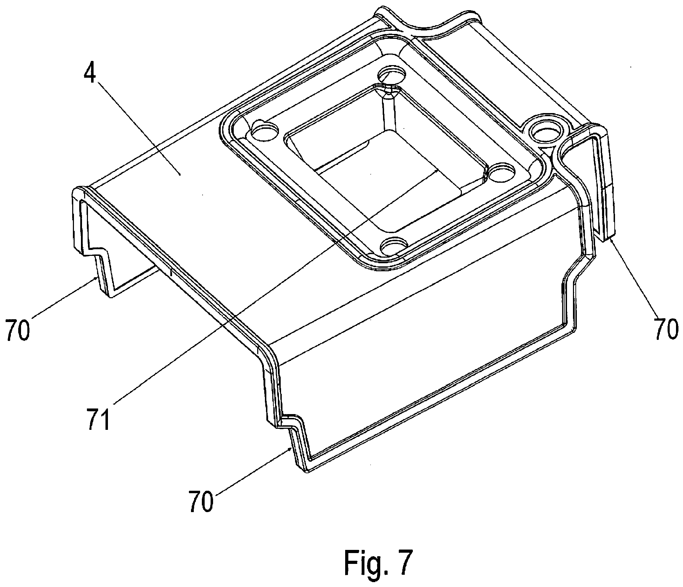

Wie in Figur 7 dargestellt, weist das Isoliermittel 4 den Schenkelbereichen 51 entsprechende Schenkelbereiche 70 auf, so dass das Isoliermittel 4 auch an der Innenseite der Schenkelbereiche 51 anliegt und somit der Wärmeübergang verschlechtert und die Isolationsfestigkeit vergrößert wird. Außerdem ist am Isoliermittel 4 ein Kragenbereich 71 ausgebildet, welcher um die vom Leistungsmodul durchdrungene Ausnehmung des Leistungsmoduls 6 umlaufend ausgebildet ist, und auf diese Weise das Leistungsmodul 6 an seinen Seiten ringsherum umgibt. Die Ausdehnung des Kragenbereichs 71 in Einführrichtung des Leistungsmoduls 6, insbesondere also in Normalenrichtung der Leiterplatte 5, ist derart weit, dass der Kragenbereich 71 bis an die Leiterplatte 5 heranreicht, also angrenzt. Somit ist die Wärmesperre und Isolation des Leistungsmoduls 6 optimiert.

Bei weiteren erfindungsgemäßen Ausführungsbeispielen ist ein zusätzlicher Lüfter am Kühlkörper 3 befestigt, so dass der vom Lüfter geförderte Luftstrom zumindest teilweise entlang der Oberfläche des Kühlkörpers 3 gefördert wird. Vorzugsweise ist zur verbesserten Lenkung des geförderten Luftstroms eine weitere Lüfterhaube vorgesehen, die am Kühlkörper 3 befestigt ist.

### Bezugszeichenliste

1 Füllmaterial
2 Deckelteil
3 Kühlkörper
4 Isoliermittel, insbesondere elektrisch isolierende und abdichtendes Verbindungsmittel
5 Leiterplattenanordnung
6 Leistungsmodul
50 Jochbereich
51 Schenkelbereich
60 Unterteil
61 Elektromotor
62 Lüfterhaube
70 Schenkelbereich
71 umlaufender Kragen

## Patentansprüche

1. Antrieb, aufweisend einen Umrichter,
wobei der Umrichter ein Unterteil (60) und ein darauf aufgesetztes Deckelteil (2) aufweist, **wobei**
ein Kühlkörper (3)
- das Deckelteil (2) zumindest teilweise umgreift
**und** Schenkelbereiche (51, 70), die voneinander beabstandet sind, und einen Jochbereich (50), der mit jedem der Schenkelbereiche (51, 70) verbunden ist, **aufweist, wobei** der Jochbereich (50) eine erste Seite des Deckelteils (2) zumindest teilweise abdeckt und ein jeweiliger Schenkelbereich (51, 70) eine jeweils unterschiedliche Seite des Deckelteils (2) zumindest teilweise abdeckt,
**wobei** eine Wärmesperre zwischen dem Kühlkörper (3) und dem Deckelteil (2) angeordnet ist,
**wobei jeder der Schenkelbereiche (51, 70) eine zur ersten Seite und zu den von den anderen Schenkelbereichen (51, 70) abgedeckten Seiten unterschiedliche Seite des Deckelteils (2) zumindest teilweise abdeckt, also jeder der Schenkelbereiche (51, 70) eine jeweils andere Seite des Deckelteils (2) zumindest teilweise abdeckt,**
**wobei die Wärmesperre ein Isoliermittel (4) umfasst, welches an einem dem Deckelteil (2) zugewandten Oberflächenbereich des Kühlkörpers (3) angeordnet ist,**
**wobei das Unterteil (60) und das mit dem Unterteil (60) verbundene Deckelteil (2) einen Raumbereich umgeben, in welchem eine Leiterplattenanordnung (5) angeordnet ist, welche mit zumindest** einem **Wärme erzeugenden Bauelement einer Signalelektronik des Umrichters und mit einem Leistungsmodul (6) des Umrichters bestückt ist,**
**wobei das Leistungsmodul (6) mit dem Kühlkörper (3) wärmeleitend verbunden ist und das Bauelement mit dem Deckelteil (2) wärmeleitend verbunden ist,**
**wobei zwischen** dem zumindest einen Wärme erzeugenden **auf einer Leiterplatte der Leiterplattenanordnung (5) angeordneten Bauelement und dem Deckelteil (2) Füllmaterial (1) angeordnet ist, das sowohl mit dem Bauelement als auch mit dem Deckelteil (2) stoffschlüssig verbunden ist,**
**wobei das Füllmaterial (1) Keramikpartikel aufweist und wärmeleitend ist,**
**wobei das Deckelteil (2) eine Ausnehmung aufweist, durch welche das Leistungsmodul (6) und der Kühlkörper (3) hindurchragt,**
**wobei das Isoliermittel (4) einen um das Leistungsmodul (6) umlaufenden Kragenbereich aufweist, der an die Leiterplatte angrenzt,**
**wobei das Isoliermittel (4) zwischen dem Kühlkörper (3) und dem Deckelteil (2) angeordnet ist,**
**wobei das Isoliermittel (4) sowohl dicht verbunden ist mit dem Kühlkörper (3) als auch dicht verbunden ist mit dem Deckelteil (2),**
**wobei das Isoliermittel (4) aus einem Kunststoff gefertigt ist** und **als Wärmesperre fungiert und/oder aus einem elektrisch isolationsfesten Material gefertigt ist.**

2. Antrieb nach Anspruch 1,
**dadurch gekennzeichnet, dass**
der Antrieb einen Elektromotor (61) aufweist,
wobei der Jochbereich (50) im Wesentlichen eben ausgeführt ist und das Deckelteil (2) an seiner vom Elektromotor (61) abgewandten Seite zumindest teilweise abdeckt.

3. Antrieb nach einem der vorangegangenen Ansprüche,
**dadurch gekennzeichnet, dass**
die insbesondere drei Schenkelbereiche (51, 70) am Jochbereich (50) abgewinkelt, insbesondere senkrecht abgewinkelt, angeordnet sind.

4. Antrieb nach einem der vorangegangenen Ansprüche,
**dadurch gekennzeichnet, dass**
der Jochbereich (50) im Wesentlichen eben ausgeführt ist und jeder der Schenkelbereiche (51, 70) sich jeweils parallel zur Normalenrichtung des Jochbereichs (50), insbesondere zum Elektromotor (61) hin, erstreckt.

5. Antrieb nach einem der vorangegangenen Ansprüche aber zumindest die Merkmale des Anspruchs 2 umfassend,
**dadurch gekennzeichnet, dass**
die B-seitige Seite des Deckelteils (2), also diejenige Seite des Deckelteils (2), welche vom aus dem Statorgehäuse des Elektromotors (61) herausstehenden, die Last antreibenden Ende der Rotorwelle am weitesten entfernt ist, vom Kühlkörper (3) nicht abgedeckt ist.

6. Antrieb nach einem der vorangegangenen Ansprüche,
**dadurch gekennzeichnet, dass**
die Wärmesperre thermisch und elektrisch isolierende Schichten oder Materialien umfasst, die zur Isolierung von Befestigungsmitteln vorgesehen sind, wobei die Befestigungsmittel den Kühlkörper (3) mit dem Deckelteil (2) verbinden, insbesondere wobei die Befestigungsmittel Schrauben sind.

7. Antrieb nach einem der vorangegangenen Ansprüche,
**dadurch gekennzeichnet, dass**
die Wärmeleitfähigkeit des Füllmaterials (1) sich von der Wärmeleitfähigkeit von Wärmeleitpaste eine um weniger als einen Faktor 2 unterscheidet.

8. Antrieb nach einem der vorangegangenen Ansprüche,
**dadurch gekennzeichnet, dass**
das Füllmaterial (1) mehrstückig ausgeführt ist,
wobei einem jeweiligen, insbesondere Wärmeerzeugenden, auf der Leiterplattenanordnung (5), insbesondere auf einer Leiterplatte der Leiterplattenanordnung (5), bestückten Bauelement ein jeweiliges Füllmaterialstück zugeordnet ist, insbesondere eineindeutig zugeordnet ist,
insbesondere wobei die Fläche der senkrechten Projektion des Füllmaterialstücks in die Leiterplattenebene die Fläche der senkrechten Projektion des Bauelements in die Leiterplattenebene nur um weniger als 50% übertrifft.

9. Antrieb nach einem der vorangegangenen Ansprüche,
**dadurch gekennzeichnet, dass**
das Füllmaterial (1) derart elastisch ausgeführt ist, dass diejenigen Änderungen des Abstands zwischen Deckelteil (2) und Bauelement, welche beim Betrieb des Umrichters thermisch bedingt sind, im elastischen Bereich der Verformung des Füllmaterials (1) kompensierbar sind,
insbesondere wobei der Abstand zwischen Deckelteil (2) und Bauelement größer als zwei Millimeter, insbesondere größer als fünf Millimeter, ist.

10. Antrieb nach einem der vorangegangenen Ansprüche,
**dadurch gekennzeichnet, dass**
zwischen dem Kühlkörper (3) und dem Leistungsmodul (6) Wärmeleitpaste angeordnet ist.

11. Antrieb nach einem der vorangegangenen Ansprüche,
**dadurch gekennzeichnet, dass**
der Antrieb einen Elektromotor (61) aufweist, auf dem der Umrichter angeordnet ist.

12. Antrieb nach Anspruch 11,
**dadurch gekennzeichnet, dass**
der Kühlkörper (3) an seiner Außenseite Kühlrippen aufweist,
welche auf der vom Elektromotor (61) abgewandten Seite des Kühlkörpers (3) derart gebogen ausgebildet sind, dass sie sich von einer jeweiligen Seitenfläche zu mindestens zwei anderen Seitenflächen, insbesondere zu drei Seitenflächen, erstrecken.

13. Antrieb nach einem der vorangegangenen Ansprüche,
**dadurch gekennzeichnet, dass**
ein zusätzlicher Lüfter am Kühlkörper (3) angeordnet ist,
insbesondere wobei der vom Lüfter geförderte Luftstrom zumindest teilweise entlang der Oberfläche des Kühlkörpers (3) strömt.

## Claims

1. Drive comprising a converter,
wherein the converter has a bottom part (60) and a cover part (2) mounted thereon, wherein a cooling member (3) at least partly encompasses the cover part (2) and has leg regions (51, 70), which are spaced apart from one another, and a yoke region (50), which is connected to each of the leg regions (51, 70), wherein the yoke region (50) at least partly covers a first side of the cover part (2), and each leg region (51, 70) at least partly covers a different side of the cover part (2) in each case,
wherein a thermal barrier is arranged between the cooling member (3) and the cover part (2),
wherein each of the leg regions (51, 70) at least partly covers a side of the cover part (2) that is different from the first side and the sides covered by the other leg regions (51, 70), i.e. each of the leg regions (51, 70) at least partly covers a different side of the cover part (2) in each case,
wherein the thermal barrier comprises an insulation means (4) which is arranged on a surface region of the cooling member (3) facing the cover part (2),
wherein the bottom part (60) and the cover part (2) connected to the bottom part (60) enclose a spatial region in which there is arranged a circuit board arrangement (5) to which at least one heat-generating component of signal electronics of the converter and also a power module (6) of the converter are fitted,
wherein the power module (6) is connected in a heat-conducting manner to the cooling member (3), and the component is connected in a heat-conducting manner to the cover part (2),
wherein filling material (1) is arranged between the cover part (2) and the at least one heat-generating component arranged on a circuit board of the circuit board arrangement (5) and is integrally bonded to both the component and the cover part (2),
wherein the filling material (1) has ceramic particles and is heat-conductive,
wherein the cover part (2) has a cut-out through which the power module (6) and the cooling member (3) project,
wherein the insulation means (4) has a collar region which extends all around the power module (6) and which adjoins the circuit board,
wherein the insulation means (4) is arranged between the cooling member (3) and the cover part (2),
wherein the insulation means (4) is both tightly connected to the cooling member (3) and tightly connected to the cover part (2),
wherein the insulation means (4) is made of a plastics material and acts as a thermal barrier and/or is made of a highly electrically insulating material.

2. Drive according to claim 1,
**characterised in that**
the drive has an electric motor (61),
the yoke region (50) being formed to be substantially planar and at least partly covering the cover part (2) on its side facing away from the electric motor (61).

3. Drive according to any of the preceding claims,
**characterised in that**
the in particular three leg regions (51, 70) are arranged in an angled manner, in particular in a vertically angled manner, on the yoke region (50).

4. Drive according to any of the preceding claims,
**characterised in that**
the yoke region (50) is formed to be substantially planar, and each of the leg regions (51, 70) extends in parallel with the normal direction of the yoke region (50) in each case, in particular towards the electric motor (61).

5. Drive according to any of the preceding claims but at least comprising the features of claim 2,
**characterised in that**
the non-drive end of the cover part (2), i.e. that side of the cover part (2) which is the furthest away from the rotor shaft end protruding out of the stator casing of the electric motor (61) and driving the load, is not covered by the cooling member (3).

6. Drive according to any of the preceding claims,
**characterised in that**
the thermal barrier comprises thermally and electrically insulating layers or materials that are intended for insulating fasteners, the fasteners connecting the cooling member (3) to the cover part (2),
the fasteners in particular being screws.

7. Drive according to any of the preceding claims,
**characterised in that**
the thermal conductivity of the filling material (1) differs from the thermal conductivity of thermal paste by less than a factor of 2.

8. Drive according to any of the preceding claims,
**characterised in that**
the filling material (1) is formed in multiple pieces,
each filling material piece being assigned, in particular unambiguously assigned, to a particular component, in particular heat-generating component, fitted on the circuit board arrangement (5), in particular on a circuit board of the circuit board arrangement (5), the area of the vertical projection of the filling material piece into the circuit board plane in particular only being less than 50% greater than the area of the vertical projection of the component into the circuit board plane.

9. Drive according to any of the preceding claims,
**characterised in that**
the filling material (1) is formed to be resilient such that the changes in the distance between the cover part (2) and the component which are induced by thermal processes while the converter is in operation can be compensated for within the elastic range of the deformation of the filling material (1),
the distance between the cover part (2) and the component in particular being greater than two millimetres, in particular greater than five millimetres.

10. Drive according to any of the preceding claims,
**characterised in that**
thermal paste is arranged between the cooling member (3) and the power module (6).

11. Drive according to any of the preceding claims,
**characterised in that**
the drive has an electric motor (61) on which the converter is arranged.

12. Drive according to claim 11,
**characterised in that**
the cooling member (3) has cooling ribs on its exterior, which are formed on the side of the cooling member (3) facing away from the electric motor (61) in a curved manner such that they extend from one particular side face to at least two other side faces, in particular to three side faces.

13. Drive according to any of the preceding claims,
**characterised in that**
an additional fan is arranged on the cooling member,
the air stream conveyed by the fan in particular flowing at least partly along the surface of the cooling member (3).

## Revendications

1. Entraînement, comprenant un convertisseur,
lequel convertisseur comprend une partie inférieure (60) et une partie supérieure (2) disposée dessus,
où
un dissipateur thermique (3)
enveloppe au moins partiellement la partie supérieure (2) et des zones de branche (51, 70), qui sont espacées l'une de l'autre, et une zone de traverse (50), qui est reliée à chacune des zones de branche (51, 70),
comprend, la zone de traverse (50) recouvrant au moins partiellement une première face de la partie supérieure (2) et chaque zone de branche (51, 70) recouvrant respectivement au moins partiellement une face différente de la partie supérieure (2),
une barrière thermique étant disposée entre le dissipateur thermique (3) et la partie supérieure (2), chaque zone de branche (51, 70) recouvrant au moins partiellement une face de la partie supérieure (2) différente de la première face et des faces recouvertes par les autres zones de branche (51, 70), donc chaque zone de branche (51, 70) recouvrant respectivement au moins partiellement une face différente de la partie supérieure (2),
la barrière thermique comprenant un matériau isolant (4) qui est disposé sur une zone de surface du dissipateur thermique (3) faisant face à la partie supérieure (2),
la partie inférieure (60) et la partie supérieure (2) reliée à la partie inférieure (60) entourant une zone d'espace dans laquelle un agencement de carte de circuit imprimé (5) est disposé,
lequel est équipé d'au moins un composant générant de la chaleur, d'une électronique de signalisation du convertisseur, et d'un module de puissance (6) du convertisseur,
le module de puissance (6) étant relié de manière thermiquement conductrice au dissipateur thermique (3) et le composant étant relié de manière thermiquement conductrice à la partie supérieure (2),
un matériau de remplissage (1) étant disposé entre le ou les composants générant de la chaleur, disposés sur une carte de circuit imprimé de l'agencement de carte de circuit imprimé (5),
et la partie supérieure (2), lequel matériau de remplissage (1) est relié de manière adhésive à la fois au composant et à la partie supérieure (2),
le matériau de remplissage (1) comprenant des particules céramiques et étant thermiquement conducteur,
la partie supérieure (2) présentant un évidement à travers lequel le module de puissance (6) et le dissipateur thermique (3) font saillie,
le matériau isolant (4) présentant une zone de collerette entourant le module de puissance (6), laquelle est adjacente à la carte de circuit imprimé,
le matériau isolant (4) étant disposé entre le dissipateur thermique (3) et la partie supérieure (2), le matériau isolant (4) étant relié de manière étanche à la fois au dissipateur thermique (3) et à la partie supérieure (2),
le matériau isolant (4) étant fabriqué en matière plastique et fonctionnant comme barrière thermique et/ou étant fabriqué à partir d'un matériau à isolation électrique renforcée.

2. Entraînement selon la revendication 1,
**caractérisé en ce que**
l'entraînement comprend un moteur électrique (61),
la zone de traverse (50) étant réalisée essentiellement plane et recouvrant au moins partiellement la partie supérieure (2) sur son côté opposé au moteur électrique (61).

3. Entraînement selon l'une des revendications précédentes,
**caractérisé en ce que**
les zones de branche (51, 70), en particulier au nombre de trois, sont disposées de manière coudée, en particulier coudées perpendiculairement, par rapport à la zone de traverse (50).

4. Entraînement selon l'une des revendications précédentes,
**caractérisé en ce que**
la zone de traverse (50) est réalisée essentiellement plane et chaque zone de branche (51, 70) s'étend respectivement parallèlement à la direction normale de la zone de traverse (50), en particulier en direction du moteur électrique (61).

5. Entraînement selon l'une des revendications précédentes mais comprenant au moins les caractéristiques de la revendication 2
**caractérisé en ce que**
le côté B de la partie supérieure (2), c'est-à-dire le côté de la partie supérieure (2) qui est le plus éloigné de l'extrémité de l'arbre du rotor sortant du boîtier de stator du moteur électrique (61) et entraînant la charge, n'est pas recouvert par le dissipateur thermique (3).

6. Entraînement selon l'une des revendications précédentes,
**caractérisé en ce que**
la barrière thermique comprend des couches ou matériaux isolants thermiquement et électriquement,
qui sont prévus pour l'isolation des moyens de fixation, les moyens de fixation reliant le dissipateur thermique (3) à la partie supérieure (2),
en particulier les moyens de fixation étant des vis.

7. Entraînement selon l'une des revendications précédentes,
**caractérisé en ce que**
la conductivité thermique du matériau de remplissage (1) diffère de la conductivité thermique de la pâte thermique d'un facteur inférieur à 2.

8. Entraînement selon l'une des revendications précédentes,
**caractérisé en ce que**
le matériau de remplissage (1) est réalisé en plusieurs parties,
un matériau de remplissage individuel étant associé à chaque composant, en particulier générateur de chaleur, monté sur l'agencement de carte de circuit imprimé (5), en particulier sur une carte de circuit imprimé de l'agencement de carte de circuit imprimé (5), en particulier associé de manière univoque,
en particulier la surface de la projection perpendiculaire du morceau de matériau de remplissage dans le plan de la carte de circuit imprimé ne dépassant la surface de la projection perpendiculaire du composant dans le plan de la carte de circuit imprimé que de moins de 50 %.

9. Entraînement selon l'une des revendications précédentes,
**caractérisé en ce que**
un ou le matériau de remplissage (1) est réalisé de manière élastique de sorte que les variations de distance entre la partie supérieure (2) et le composant, qui sont dues à la température lors du fonctionnement du convertisseur, sont compensables dans le domaine élastique de la déformation du matériau de remplissage (1),
en particulier la distance entre la partie supérieure (2) et le composant étant supérieure à deux millimètres, en particulier supérieure à cinq millimètres.

10. Entraînement selon l'une des revendications précédentes,
**caractérisé en ce que**
de la pâte thermique est disposée entre le dissipateur thermique (3) et le module de puissance (6).

11. Entraînement selon l'une des revendications précédentes,
**caractérisé en ce que**
l'entraînement comprend un moteur électrique (61), sur lequel le convertisseur est disposé.

12. Entraînement selon la revendication 11,
**caractérisé en ce que**
le dissipateur thermique (3) présente sur son côté extérieur des ailettes de refroidissement, lesquelles sont formées de manière courbée sur le côté du dissipateur thermique (3) opposé au moteur électrique (61), de sorte qu'elles s'étendent d'une surface latérale respective vers au moins deux autres surfaces latérales, en particulier vers trois surfaces latérales.

13. Entraînement selon l'une des revendications précédentes,
**caractérisé en ce que**
un ventilateur supplémentaire est disposé sur le dissipateur thermique (3),
en particulier le flux d'air généré par le ventilateur s'écoulant au moins partiellement le long de la surface du dissipateur thermique (3).
